# EUROPEAN PATENT APPLICATION

(11) **EP 1 731 949 A1**
(43) Date of publication of application: **13.12.2006**
(21) Application number: 04821899.4
(22) Date of filing: 08.12.2004
(51) Int. Cl.: G02F 1/00

(54) **LIQUID CRYSTAL PANEL, MANUFACTURING METHOD THEREOF, AND ELECTRONIC DEVICE USING THE LIQUID CRYSTAL PANEL**

(30) Priority: 31.03.2004 JP 2004106300
(71) Applicant: NEC CORPORATION, Minato-ku, Tokyo 108-8001 (JP); Dainippon Printing Co., Ltd., Tokyo 162-8001 (JP); KONICA MINOLTA HOLDINGS, INC., Tokyo 100-0005 (JP); JSR Corporation, Tokyo 104-8410 (JP); Sumitomo Chemical Company, Limited, Tokyo 104-8260 (JP); Sumitomo Bakelite Company, Limited, Tokyo 140-0002 (JP); Dainippon Ink and Chemicals, Incorporated, Itabashi-ku Tokyo 174-8520 (JP); TORAY INDUSTRIES, INC., Tokyo 103-8666 (JP); Toppan Printing Co., Ltd., Taito-ku, Tokyo 110-0016 (JP); Hitachi Chemical Company, Ltd., Shinjuku-ku, Tokyo 163-0449 (JP)
(72) Inventor: TAKECHI, K., NEC Corporation, Tokyo 1088001 (JP); SUMIYOSHI, K., NEC Corporation, Tokyo 1088001 (JP); FUJIEDA, I., NEC Corporation, Tokyo 1088001 (JP); TAKAHASHI, T., Dai Nippon Printing Co., Ltd, Shinjuku-ku, Tokyo 1628001 (JP); GENDA, K., Konica Minolta Techn. Ctr Inc, Tokyo 1928505 (JP); KUMANO, A., JSR Corporation, Tokyo 1048410 (JP); OSHIMA, N., JSR Corporation, Tokyo 1048410 (JP); MATSUOKA, Y., Sumitomo Chemical Company, Ltd, Niihama-shi, Ehime 7920001 (JP); EGUCHI, T., Sumitomo Bakelite Co., Ltd., Shinagawa-ku, Tokyo 1400002 (JP); YAMAOKA, S., Sumitomo Bakelite Co., Ltd, Shinagawa-ku, Tokyo 1400002 (JP); ONO, Yoshiyuki, 2891105 (JP); YONEHARA, Hisatomo, 2850034 (JP); SUZUKI, Motoyuki, 5200105 (JP); TSUKUDA, Akimitsu, 5202153 (JP); SEKINE, N., Toppan Printing Co., Ltd., Tokyo 1108560 (JP)
(74) Representative: Mathys & Squire
(86) International application number: PCT/JP2004/018243
(87) International publication number: WO 2005/101107

(57) **Abstract**

A semi-transmissive liquid-crystal panel is a useful mobile display device which can provide a clear image in both dark and bright places. However, there has been needed a light-weighted and highly durable display device with a lower power consumption, pursing advantages of a single transparent/reflection type liquid-crystal panel.

According to this invention, there is provided a liquid crystal display panel comprising a rear-emitting light source, comprising a liquid crystal device formed on a first substrate in which a liquid crystal layer is sandwiched between a transparent first electrode and a transparent second electrode which at least face each other and a rear-emitting light source for the liquid crystal device formed on a second substrate in which a thin-film flat light emitting device is sandwiched between an optically opaque third electrode and a transparent fourth electrode which at least face each other, wherein the third electrode is a reflection film disposed in the side of the second substrate, which reflects an outside light entering via the liquid crystal layer into the liquid crystal layer; and the fourth electrode is disposed facing the second electrode, and the insulating film sandwiched between the fourth electrode and the second electrode is a film continuously formed on the fourth electrode.

## Description

### TECHNICAL FIELD

This invention relates to a liquid-crystal panel, a manufacturing process therefor and an electronic device equipped with a liquid-crystal panel.

### BACKGROUND ART

As an information society has been recently developed, a conventional CRT (Cathode Ray Tube) display conventionally used as an imaging apparatus in an information device has been replaced by a flat display due to its larger size.

Application of information devices have been expanded from indoor stationary types to mobile types. In contrast to stationary types, mobile type information devices are used in various situations.

Known flat displays include a plasma display, a liquid crystal display and an organic EL display (Organic Light Emitted Display). A plasma display is not suitable for a mobile device because it requires a high voltage from its operation principle, while a liquid crystal display and an organic EL display which can be operated with low power consumption are suitable for a mobile device. Although liquid crystal displays prevail at present, it is expected that organic EL displays will be increased because of their clear picture.

Organic EL displays and liquid crystal displays are classified into "active driving types" where each pixel is equipped with an active device for driving, and "simple matrix types" where a pixel is driven by two groups of orthogonal electrodes. An active driving type can drastically reduce a response time in comparison with a simple matrix type, allowing a number of pixels to be used for movie displaying. Furthermore, it can more precisely control image-quality factors such as contrast and gradation. As a result, an "active driving type" is now a dominant driving system.

Liquid crystal displays can be classified into three groups, i. e., transmission, reflection and semi-transmissive types, in which a pixel electrode transmits, reflects or partially transmits and partially reflects a light, respectively.

When a device is exclusively for indoor use as a stationary type, an image is clear in a transmissive liquid crystal display or an organic EL display. However, image contrast is deteriorated in an outdoor area which is brighter than emission intensity of natural light, leading to an obscure image. When a light source is intensified for preventing contrast deterioration outside, dazzling occurs in an indoor image and power consumption is increased.

In contrast, a reflective liquid crystal display has an advantage of higher outdoor visibility because it reflects an outside light to display an image, but has a drawback that an image is obscure in a dark place. Although the problem can be improved by incorporating a front light, a front light has a drawback that it cannot evenly illuminate the whole display.

There is a semi-transmissive liquid crystal display as a liquid crystal display with advantages of the transmission and the reflective types. A semi-transmissive liquid crystal display utilizes both backlight and outside light for displaying, by making a pixel electrode semi-transparence or forming an opening, ensuring visibility in both outdoor and indoor places. In most of mobile information terminals, semi-transmissive liquid-crystal panels are used at present.

However, an image in a semi-transmissive liquid crystal display is inferior to that in a transmissive liquid crystal display or organic EL display in a dark place and inferior to that in a reflective liquid crystal display in a bright place. Therefore, it is necessary to further improve image quality for using it as a mobile information terminal.

Furthermore, displays are used in a wide variety of private and commercial applications including information terminals such as mobile devices, e. g., a cell phone and a PDA (Personal Digital Assistant), digital cameras and digital video cameras, which are used in various places. Thus, such display apparatus are required to be robust.

Properties needed in a display panel for a mobile device include, in addition to image quality described above, a display size, panel thinness and power consumption.

Robustness leads to a thinner panel. It is necessary to use a substrate resistant to impact. In terms of a thickness of a panel, an organic EL display can be thinned to a thickness of one substrate in principle. In contrast, for a liquid crystal display panel, a reflective liquid crystal display can be thinned to a thickness of two substrates, while a transmission/semi-transmission type liquid crystal display inevitably becomes thicker because it requires a backlight.

On the other hand, improvement in size reduction, robustness and an electrical power consumption has been attempted by forming, on a glass substrate, a transistor for a pixel and a driving circuit conventionally provided as an external device by means of low-temperature polycrystalline silicon thin-film transistor (poly-Si TFT) technique.

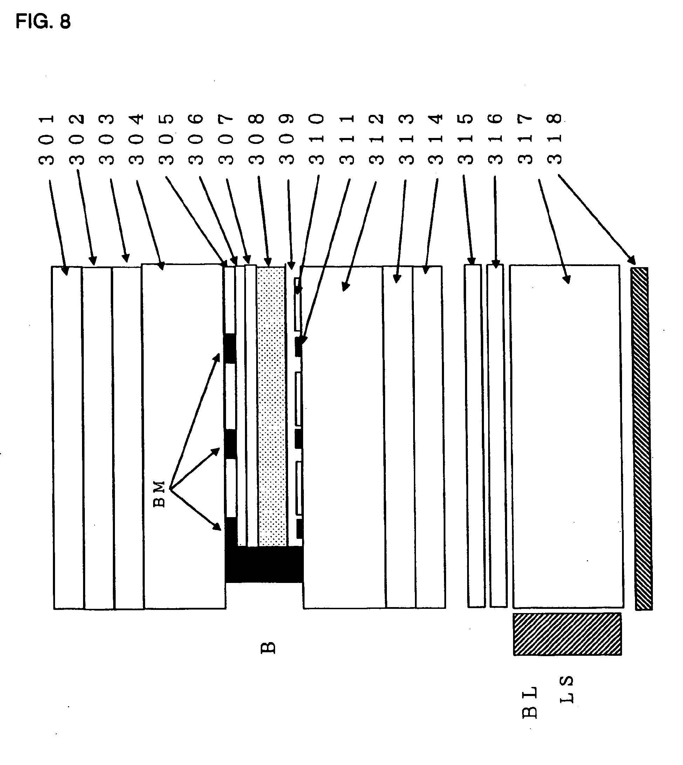

FIG. 8 shows a cross-sectional view of a conventional semi-transmissive liquid crystal display panel. A liquid-crystal panel has a configuration that a liquid crystal is sandwiched by two substrates as shown in the upper par of FIG. 8. On one side of one substrate 312, there are regularly arranged pixels comprising a TFT 311 and a pixel electrode 310, and there is formed an interconnection for transferring a signal for driving the TFT 311. The pixel electrode 310 is made of a semi-transparent material.

The pixel electrode 310 is designed to have a transmittance of 30 to 70 %; often a transmittance of 70 %.

On one side of the other substrate 304, there is arranged a color filter 305. The color filter 305 consists of a color filter unit of red, green and blue and a black matrix for shielding. The color filter unit of red, green and blue is disposed facing the pixel electrode 310 while the black matrix (BM) is disposed facing a boundary between pixel electrodes. A transparent electrode is formed such that it covers the color filter 305. On the surfaces of these two glass substrates 304, 312, there are formed oriented films 307, 309, respectively, for orienting a liquid crystal to a desired direction. These two substrates are fixed by a sealing material B disposed on the periphery of the substrates. A liquid crystal fills the space between these two substrates.

On the outer surfaces of each of these two glass substrates 304, 312 sandwiching the liquid crystal, there is attached a film substrate having various optical functions. In FIG. 8, two film substrates, i. e., a polarizing plate (linear polarizing plate) 302, 314 and a retardation film (1/4 wavelength plate) 303, 313, are laminated for converting an incident light into a circularly-polarized light. Furthermore, there is provided an antireflective plate 301 for preventing reflection of an outside light.

When applying the sealing material B, an opening is left for later injecting a liquid crystal. Spacers corresponding to a given space distance (for example, about 3 µm to 6 µm) are distributed for maintaining the given distance between these two glass substrates 304, 312. The spacers are considerably smaller than a pixel electrode. After firing them under a certain load, a liquid crystal 308 is injected from the opening (not shown) in the sealing material. Finally, the opening in the sealing material B is sealed with a UV-curable material to provide a liquid-crystal panel.

The lower part of FIG. 8 shows a configuration of a backlight. The backlight consists of a light source C emitting a white light such as a lamp and a light-emitting diode (LED), an optical guide 317, a reflection plate 318, a diffusion sheet 316 and a field-angle regulating sheet 315.

A configuration of these components is optimized to allow the backlight to operate as a plane light emitter as even as possible and to guide a light from the light source C toward a liquid-crystal panel as efficiently as possible. In general, an optical guide 317 is a transparent plastic substrate made of polymethyl methacrylate (PMMA) with a thickness of, for example, about 1.0 mm. The reflection plate 318, the diffusion sheet 316 and the field-angle regulating sheet 315 have been processed to effect individual optical functions. Thus, the overall thickness of the backlight components in FIG. 8 is about 2.0 mm.

There will be described operation of a semi-transmissive liquid crystal display as a transmissive liquid crystal display with reference to FIG. 8.

A white light from the light source C enters the optical guide 317, alters its path by the reflection plate 318 and then is diffused by the diffusion sheet 316. The diffused light is adjusted by the field-angle regulating sheet 315 to have a desired orientation and then reaches the liquid-crystal panel.

Although this light is non-polarized, only one linearly-polarized light passes through the straight polarizing plate 312 in the liquid-crystal panel. The linearly-polarized light is converted into a circularly-polarized light by the retardation film (1/4 wavelength plate) 311, and sequentially passes through the substrate 303, the pixel electrode 310 made of a semi-transparent material, finally to the liquid crystal layer.

Orientation of the liquid crystal molecules are controlled, depending on the presence of a potential difference between the pixel electrode 310 and the opposite transparent electrode (counter electrode) 306. That is, in an extreme orientation state, a circularly-polarized light entering from the lower part of FIG. 8 is transmitted, as it is, through the liquid crystal layer 308 and then through the transparent electrode 306. Then, a light with a particular wavelength is transmitted through the color filter to the retardation film (1 /4 wavelength plate) 303. Thus, it substantially completely passes through the polarizing plate (straight polarizing plate) 302. The pixel, therefore, most brightly displays a color determined by the color filter.

In contrast, in another extreme orientation state, polarity of a light passing through the liquid crystal layer is altered, so that a light passing through the color filter is substantially completely absorbed by the retardation film (1 /4 wavelength plate) 303 and the polarizing plate (straight polarizing plate) 302. Thus, the pixel displays black color. In an intermediate orientation state between these two states, a light is partially transmitted, so that the pixel displays an intermediate color.

Next, there will be described operation of a semi-transmissive liquid crystal display as a reflective liquid crystal display.

When an outside light enters a liquid-crystal panel from the upper part of FIG. 8, a circularly-polarized light which has been transmitted through the polarizing plate (straight polarizing plate)302 and the retardation film (1 /4 wavelength plate) 303, passes through a liquid crystal layer. Then, 30 % of the light power is reflected by a pixel electrode to be utilized for displaying. Therefore, the display operates as a reflective liquid crystal display.

A conventional transmissive/semi-transmissive liquid crystal display is thick and heavy because it uses a backlight. For solving the problem, there has been proposed a configuration using an organic EL.

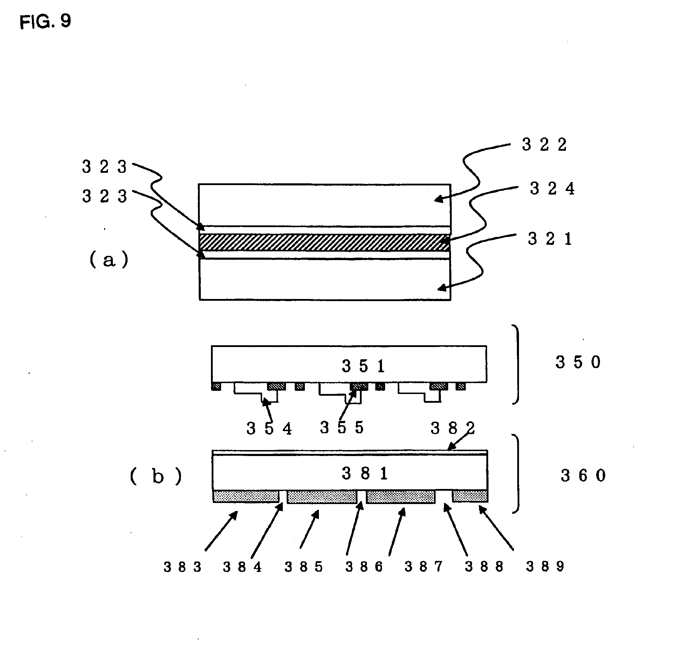

Japanese Patent Application Nos. 2000-29034 and 2002-98957 have disclosed a configuration using an organic EL as a backlight, which will be described below with reference to FIG. 9.

Japanese Patent Application No. 2000-29034 has described that in order to prevent an organic EL from being deteriorated during forming an oriented film by a conventional firing process, an oriented film 323 which has been preliminarily oriented is laminated with a display-driving substrate 321 and a counter substrate 322. Such lamination can prevent an organic EL from being deteriorated by avoiding exposure to a high temperature during forming the oriented film by a conventional firing process.

The liquid crystal display panel in FIG. 9A is manufactured as follows. First, a TFT array substrate 621 and a counter substrate 622 comprising a plane light emitter which are produced by separate processes, are laminated. Then, the product is subject to common rubbing to provide the polymer film with an orientating function to the liquid crystal composition 624 to form an oriented film 623. Then, the TFT array substrate 621 and the oriented film 623 to the counter substrate 622 are disposed, facing each other. Then, the space between them is filled with a liquid crystal composition 624.

In the structure in FIG. 9A, an organic film is laminated with the oriented film according to the prior art as shown in FIG. 8, and a backlight is replaced with an organic EL. Although a substrate for forming the organic EL is needed, a light-emitting part consisting of the organic EL is a thin film while a conventional optical guide has a thickness of several mm. Thus, it can be thinned to a glass substrate thickness of about 0.4 mm.

Japanese Patent Application No. 2000-98957 has disclosed that in a transmissive liquid-crystal panel, an organic EL light-emitting device is used in place of a conventional fluorescent tube as a backlight for reducing a film thickness and a weight. FIG. 9B shows its structure.

The liquid crystal display panel comprises a first electrode substrate 350, a second electrode substrate 360 and a liquid crystal layer 380 between these substrates.

The first electrode substrate 350 is comprised of a transparent glass substrate 351, whose surface to be in contact with a liquid crystal layer 380, comprises a scan line 352, a signal line 353 (not shown), a pixel electrode 354, a TFT 355, an auxiliary capacity 356 (not shown) and an auxiliary capacity line 357.

In the second electrode substrate 380, a transparent glass substrate 381 has a surface to be in contact with a liquid crystal on which a transparent electrode 382 to be a counter electrode to a liquid crystal device and a surface facing the surface comprising substrate transparent electrode 382 in the glass substrate 381 comprises emitting parts 383, 385, 387, 389 in an organic EL and non-emitting parts 384, 386, 388 as spaces between the emitting parts 383, 385, 387,389.

FIG. 9B shows that a film thickness can be reduced by eliminating an optical guide for a backlight which has been required in the prior art, by means of forming a thin-film plane light-emitting device consisting of an organic EL on the rear surface of the substrate on which a counter electrode in a liquid-crystal panel is to be formed. Thus, the number of substrates can be reduced to two while the conventional configuration needs three substrates as shown in FIG. 9A, resulting in thickness reduction in a liquid-crystal panel.

However, these liquid-crystal panels are transparent, which are not manufactured, taking into account the use under various illumination conditions, e. g., a cell phone which may be used during moving from a dark place to a bright place.

Thus, an objective of this invention is to provide a liquid-crystal panel which is all-weather, can be used in both dark and bright places, is more easily viewable than a conventional semi-transmissive liquid-crystal panel in both dark and bright places and can be used with a reduced power consumption.
Patent Document 1: JP-2000-29034-A
Patent Document 2: JP-2002-98957-A

### DISCLOSURE OF THE INVENTION

### Problems to be Solved by the Invention

As described above, a conventional semi-transmissive liquid crystal display has a configuration that on a substrate are laminated optical films having various functions such as anti-reflection, polarization and phase retardation and a backlight is disposed on the rear surface.

By employing the structure described in Japanese Patent Application No. 2002-9857 for a backlight in a semi-transmissive liquid crystal device, the number of substrates can be reduced to two, allowing a liquid-crystal panel to be thinned.

However, even when using an organic EL as a backlight, it is necessary that a pixel electrode is designed to have a transmittance of 30 to 70 % in a semi-transmissive liquid crystal device. Generally, its transmittance is 30 %.

Here, in a bright place, only 70 % of an outside light entering a liquid crystal is utilized. Furthermore, since 70 % of a light emitted from the backlight is not utilized, the backlight must emit a light with three times as much illumination as that needed, leading to an undue power consumption.

If both reflectance and transmittance are 100 %, the device can be used in a darker place, allowing a needed illumination in a backlight to be reduced. Since the transmittance is 100 %, the backlight should emit a light just at the needed illumination, resulting in reduction in a power consumption.

In a mobile device such as a cell phone to which a power is supplied not from a fixed power supply by a battery, reduction in a power consumption is an essential problem in addition to viewability of a display.

Thus, an objective of this invention is to provide a liquid-crystal panel which is more easily viewable than a conventional semi-transmissive liquid-crystal panel in both dark and bright places and can be used with a reduced power consumption.

### Means for Solving the Problems

According to this invention, a rear-emitting light source and a liquid crystal are integrated without an intervening substrate and a reflection film to an outside light into a liquid crystal is formed on a surface opposite to a surface adjacent to the liquid crystal in the rear-emitting light source.

In the liquid-crystal panel comprising the rear-emitting light source according to this invention, a substrate does not intervene between the liquid crystal and the rear-emitting light source and further, an optical guide is not used. As a result, a reflection film can be also formed the electrode in the rear-emitting light source or a substrate on which the rear-emitting light source is formed, to reduce a distance between the reflection film and a pixel electrode which an outside light into the liquid crystal enter. Thus, an efficiency of the outside light is not reduced. It is, therefore, not necessary to make a pixel electrode reflective as in a conventional semi-transmissive liquid crystal.

It is desirable that a distance between the electrode in the side which an outside light into the liquid crystal enter and a reflection film is equal to or smaller than the distance between pixel electrodes. When a distance between the electrode in the side which an outside light into the liquid crystal enter and a reflection film is equal to the distance between pixel electrodes, a light efficiency can be improved in comparison with a conventional semi-transparent liquid-crystal panel designed such that a reflectance in a pixel electrode is 30 %. As the distance is smaller, an efficiency is increased.

A higher light efficiency may allow a reflective liquid crystal to be used in a darker place without lighting a backlight, which contributes to reduction in a power consumption.

There is provided a liquid crystal display panel comprising a rear-emitting light source, comprising
a liquid crystal device formed on a first substrate in which a liquid crystal layer is sandwiched between a transparent first electrode and a transparent second electrode which at least face each other and
a rear-emitting light source for the liquid crystal device formed on a second substrate in which a thin-film flat light emitting device is sandwiched between an optically opaque third electrode and a transparent fourth electrode which at least face each other, wherein
the third electrode is a reflection film disposed in the side of the second substrate, which reflects an outside light entering through the liquid crystal layer into the liquid crystal layer; and
the fourth electrode is disposed facing the second electrode, and the insulating film sandwiched between the fourth electrode and the second electrode is a film continuously formed on the fourth electrode.

This invention also provides a liquid crystal display panel wherein
a rear-emitting light source comprises a reflection film formed between a substrate and one surface of a thin-film flat light emitting device, and a transparent electrode formed on the other surface of the thin-film flat light emitting device;
an outside light from a liquid crystal device enters the reflection film through the transparent electrode;
the outside light reflected by the reflection film enters the liquid crystal device through the transparent electrode; and
the liquid crystal device is adjacent to the rear-emitting light source by the intermediary of a film continuously formed at least on the transparent electrode.

### Effect of the Invention

According to this invention, in contrast to a conventional semi-transmissive liquid-crystal panel, an outside light can be completely reflected and a backlight can be completely transmitted without any restrictions to reflection of an outside light or transmission of a backlight beam. Although there are practically some problems in terms of, for example, a reflection efficiency of a reflection film and a film transmittance, theoretically an outside light can be 100 % reflected in a bright place to allow the device to operate as a reflective liquid-crystal panel and a backlight can be 100 % transmitted in a dark place to allow the device to operate as a transmissive liquid-crystal panel.

As a result, in comparison with a conventional semi-transmissive liquid-crystal panel, a light efficiency is increased and display in a bright place is clearer. Thus, the device can be operated as a reflection type liquid-crystal panel in a darker place compared to a conventional device and an intensity of a backlight can be reduced in a dark place.

According to this invention, a backlight can be OFF under wider conditions. Thus, a period for which a backlight is OFF can be reduced and a backlight illumination can be reduced, so that a power consumption can be reduced and, in a mobile device driven by a battery, a battery life can be increased.

### BRIEF DESCRIPTION OF DRAWINGS

FIG. 1 is a cross-sectional view schematically showing a liquid-crystal panel of this invention.
FIG. 2 shows a cross section of a protective film protecting an organic EL layer.
FIG. 3 is a process cross-sectional view illustrating a process for manufacturing a thin-film transistor on a substrate.
FIG. 4 is a cross-sectional view schematically showing an organic EL device.
FIG. 5 is a cross-sectional view schematically showing a variation of this invention.
FIG. 6 is a process cross-sectional view illustrating a manufacturing process in which a thin-film transistor of this invention is transferred on another substrate.
FIG. 7 is a schematic cross-sectional view illustrating another variation of this invention.
FIG. 8 is a cross-sectional view schematically showing a conventional semi-transmissive liquid-crystal panel.
FIG. 9 is a schematic cross-sectional view of a transmissive liquid-crystal panel comprising an organic EL device as a rear-emitting light source.

### Description of the Symbols

In these drawings, the symbols have the following meanings; 100: polarizing film, 101: glass substrate, 104: color filter, 102: thin-film transistor, interconnection, 103: pixel electrode, 105: oriented film, 106: liquid crystal, 107: oriented film, 108: counter electrode, 109: retardation film, 110: polarizing film, 111: transparent electrode, 112: organic EL layer, 113: reflection electrode, 114: glass substrate, A: spacer, 115: protective film, 122: anode, 123: cathode, 124: hole transporting layer, 125: light-emitting layer, 126: reflection film, 127: ITO film, 128: glass substrate, 129 transistor array layer, 130: protective film, 131: glass etchant, 132: substrate with a color filter, 133: adhesive, 301 antireflective plate, 302: polarizing plate, 303: retardation film, 304: glass substrate, 305: color filter, 306: transparent electrode, 307: oriented film, 308: liquid crystal, 309: oriented film, 310: pixel electrode, 311: interconnection, thin-film transistor, 312: glass substrate, 313: retardation film, 314: polarizing plate, 315: field-angle regulating sheet, 316: diffusion sheet, 317: optical guide, 318: reflection plate, 321: display-driving substrate, 323: oriented film, 322: counter substrate, and 324: liquid crystal composition.

### BEST MODE FOR CARRYING OUT THE INVENTION

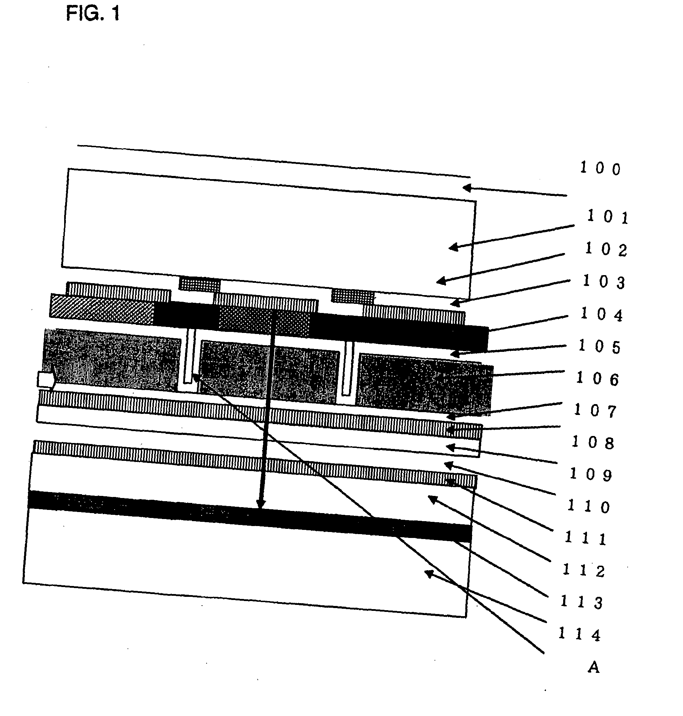

A first embodiment of this invention will be described with reference to a schematic view in FIG. 1. FIG. 1 is a cross-sectional view of a liquid crystal display panel with a backlight of this first embodiment.

By a known method, on a silicon film formed on a first glass substrate 101 are formed a thin-film transistor, an interconnection 102, a color filter 104, then a pixel electrode 103 as a transparent electrode and finally an oriented film 105.

On a second glass substrate 114 are formed a reflection electrode 113, an organic EL layer 112 to be a light-emitting layer in a thin-film light emitting device, a transparent electrode 111, a polarizing film 110, a retardation film 109, a counter electrode 108 as a transparent electrode for a liquid crystal, and an orienting plate 107. The liquid crystal 106 is sandwiched between the orienting plate film 105 and the oriented film 107. A spacer A is for ensuring a distance between the oriented film 105 and the oriented film 108.

A pitch of pixel electrodes depends on a resolution of the active driving type liquid crystal display panel. For example, for an active driving type liquid-crystal panel comprising three color filters of R (red), G (green) and B (blue) with a resolution of 200 ppi (pixel x electrode (EL) per inch), a pitch of pixel electrodes is 25400 µm/200/3 = 42.3 µm.

When a distance between the surface of the first glass substrate comprising the pixel electrode and the surface of the reflection electrode is adequately smaller than 42.3 µm as the pixel electrode pitch, it is not possible that an efficiency of an outside light is reduced due to entering of the outside light reflected by the reflection electrode into an adjacent pixel.

In the structure in FIG. 1, no substrates intervenes between the light emitting device and the liquid crystal device, resulting in reduction in a distance between the surface of the first glass substrate comprising a pixel electrode and the surface of the reflection electrode. Here, when the transparent electrode constituting the pixel electrode has a higher refractive index than the substrate, an outside light efficiency can be increased.

Although an organic EL device may be replaced with a thin-film flat light emitting device like an inorganic EL device, it may be understood that an organic EL device is the most preferable light emitting device in terms of a light-emitting efficiency. Since a light-emitting part in an organic EL device is an organic compound, the light-emitting part must be protected from an external atmosphere (e. g., moisture, oxygen). Thus, it is desirable to form a protective film made of SiO₂, SiN, Al₂O₃ or AIN. It is, of course, desirable that a light-emitting part, even when it is not made of an organic compound, is protected by a protective film.

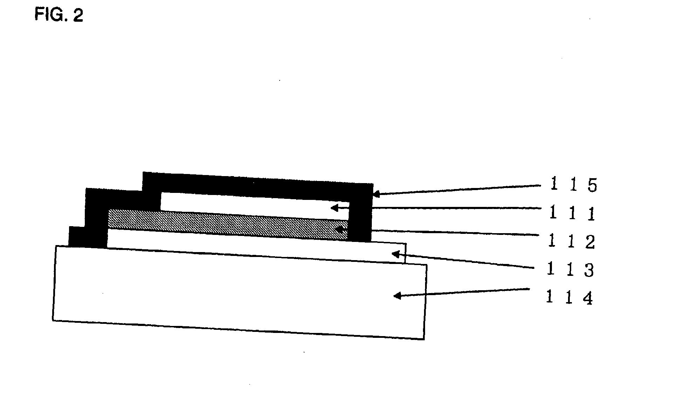

The protective film preferably covers the edge of the organic EL layer 112 as a light-emitting layer in the thin film light emitting device and the upper surface of the organic EL layer 112 not covered by the transparent electrode 111 as shown in FIG. 2. The film can be made of any material which can protect a light emitting device from an external atmosphere, but preferably made of an inorganic material such as SiO₂, SiN, Al₂O₃ and AIN. There are no particular restrictions to an upper limit of its thickness, but it is preferably 1000 nm or less in the light of, for example, a manufacturing efficiency.

When using a substrate made of an organic resin, it is preferable that a barrier film is formed on at least one side of the substrate for protecting a device unit (light emitting device/liquid crystal device) from an external atmosphere (moisture, oxygen, etc.). The barrier film is preferably formed on a liquid crystal layer in the substrate or a surface where a thin-film flat light emitting device is to be formed, more preferably on both sides of the substrate. The barrier film is made of a material including organic materials such as polyvinyl alcohols; organic-inorganic composite materials such as those of an organic material with an inorganic material including a clay mineral (an amorphous clay mineral such as Al₂O₃-2SiO₂ • 5H₂O and Al₂O₃ • SiO₂ • 2-3H₂O, or a crystalline clay mineral such as (Si,Al)O₄ tetrahedral sheet and (Al,Mg)(O,OH)₆ octahedral sheet); and inorganic materials such as SiO₂, SiN, Al₂O₃ and AIN. A thickness of a gas barrier layer is preferably 1 to 10 µm when it is made of an organic material or an organic-inorganic composite material and preferably 10 nm to 1 µm when it is made of an inorganic material. When it is made of an organic material or an organic-inorganic composite material, a thickness of 1 µm or more can adequately prevent common air components such as oxygen and moisture from entering a liquid crystal layer or an organic EL layer.

With a thickness of 10 µm or less, the film is not influenced by an expansion coefficient. When it is made of an inorganic material, a thickness of 10 nm or more can adequately prevent common air components such as oxygen and moisture from entering a liquid crystal layer or an organic EL layer, while a thickness of 1 µm or less does not cause any manufacturing problems.

Although the driving electrode in the thin-film flat light emitting device is used as a reflection film for an outside light in this example, a separate reflection film may be used in addition to the driving electrode. When the reflection film is made of an electrically conductive material exhibiting a higher reflection efficiency such as aluminum, gold and silver, the driving electrode must be disposed by the intermediary of an insulating film.

The reflection film may have an irregular shape with a height of about 1 µm. By the irregularity, the reflection film can diffuse a light, so that interference by an external image can be prevented. A size distribution in the irregularity may be random to further reduce interference by an external image.

As detailed in Examples, the individual layers in the liquid-crystal panel shown in FIG. 1 are as follows, i. e., the transparent electrode 111, the counter electrode 108 and the pixel electrode 103 are ITO films with a thickness of 0.1 µm to 0.2 µm; the thin-film transistor and the interconnection are polycrystalline silicon or metal films (generally, aluminum or an aluminum alloy) with a thickness of 0.1 µm to 0.2 µm; the organic EL layer 112 to be a light-emitting layer in a thin-film light emitting device is made of an organic composition with a thickness of several ten nanometers several hundred nanometers (the order of 10⁻² to 10⁻¹ µm); the liquid crystal part 106 has a thickness of 2 µm to 6 µm; the retardation film 109 has a thickness of 0.5 µm to 10 µm; the polarizing film 110 has a thickness of 5 µm to 50 µm; the oriented films 105, 107 have a thickness of 0.1 µm to 0.2 µm; and the color filter 104 has a thickness of several micrometers.

Since a distance between the color filter 104 and the reflection electrode 113 is about 20 µm, which is adequately smaller than 42.3 µm, i. e., the pixel electrode pitch, it is not possible that an efficiency of an outside light is reduced due to entering of the outside light reflected by the reflection electrode into an adjacent pixel.

There will be further specifically described the first example of this invention with reference to FIG. 1 which is a cross-sectional view of an active driving type liquid-crystal panel.

In the active driving type liquid-crystal panel of this example, on one surface of the first glass substrate 101 as a supporting substrate are formed a thin-film transistor circuit consisting of the thin-film transistor 102, the pixel electrode 103, the thin-film transistor 102, the color filter 104 (consisting of red (R), green (G), blue (B) and a black matrix) via a protective film (not shown) for protecting the pixel electrode, the spacer A and the oriented film 105.

The spacer A may be formed in the side of the substrate where a thin-film flat light emitting device (backlight source) is formed.

In the thin-film flat light emitting device to be a backlight source (in this example, it is described using an organic EL device), on the second glass substrate 114 facing the first glass substrate 101 are formed the reflection electrode 113, the organic EL layer 112 to be a light-emitting layer, the transparent electrode 111, the polarizing film 110, the retardation film 119, the counter electrode 108 which is a counter electrode to the pixel electrode 103 and the oriented film 107, and the liquid crystal 106 is sandwiched between the oriented film 105 on the first glass electrode and the oriented film 107 on the second electrode.

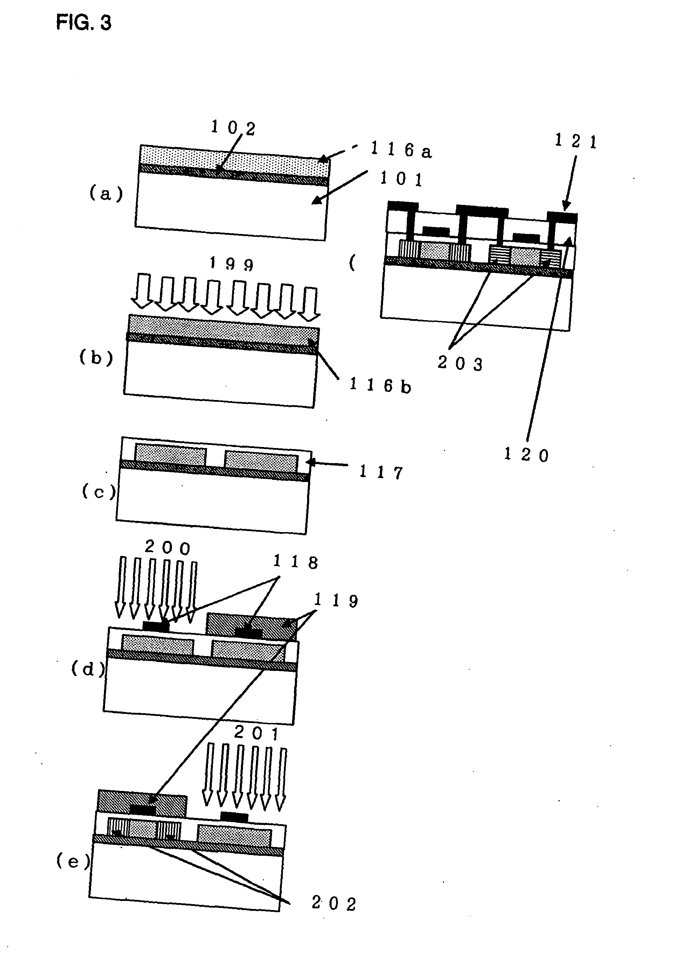

There will be described a process for manufacturing a driving circuit for a liquid crystal device (a pixel electrode driving a liquid crystal and peripheral circuits) and its structure with reference to FIG. 3.

As shown in FIG. 3A, on a glass substrate 101 is deposited an amorphous silicon film or a polycrystalline silicon film. In this example, an amorphous silicon film 116a was deposited to 100 nm.

Before depositing the amorphous silicon film or the polycrystalline silicon film, a silicon oxide film may be formed on the glass substrate 101.

These thin films may be deposited by plasma CVD or sputtering. Then, as shown in FIG. 3B, the amorphous silicon film is irradiated with excimer laser to be modified into a polycrystalline silicon film 116b.

As shown in FIG. 3C, a polycrystalline silicon film 116b is patterned into a desired shape, on which a gate insulating film 117 as an oxide film is then deposited to 100 nm by, for example, plasma CVD or sputtering. Then, as shown in FIG. 3D, a gate electrode 118 is formed, an area in which an n-channel transistor is to be formed is covered by a photoresist 119 and then boron is implanted by ion doping to form a p-type area. Subsequently, as shown in FIG. 3E, an area in which a p-channel transistor is to be formed is covered by a photoresist 119 and phosphorus is implanted by ion doping to form an n-type area. Then, as shown in FIG. 3F, a source and a drain electrodes made of aluminum are formed. Then, an inter-layer insulating film 120 as an oxide film is formed to 200 nm and an aluminum metal electrode 121 is formed to a thickness of 150 nm to provide a transistor constituting peripheral circuits. Furthermore, a pixel-driving transistor unit for driving pixels in a liquid-crystal panel may be constituted by an n-MOS or p-MOS transistor alone. Such a transistor array can be appropriately arranged to form a desired circuit on a glass substrate. In the pixel-driving transistor unit, a transparent conductive film made of ITO (Indium Tin Oxide) is further deposited to form a desired pixel electrode. Finally, an oxide film with a thickness of 200 nm is formed as an electrode protective film for protecting the electrode. Thus, there is provided a TFT glass substrate for a liquid crystal display panel.

As described above, the layer in which a transistor constituting a driving unit for a liquid crystal display unit must have a thickness of 600 to 1000 nm (0.6 to 1 µm).

There will be described an organic EL device as an example of a thin-film flat light emitting device in this example.

The organic EL device has a configuration that a light-emitting layer made of an organic EL material is sandwiched by a reflection electrode which reflects a light and a transparent electrode through which a light passes.

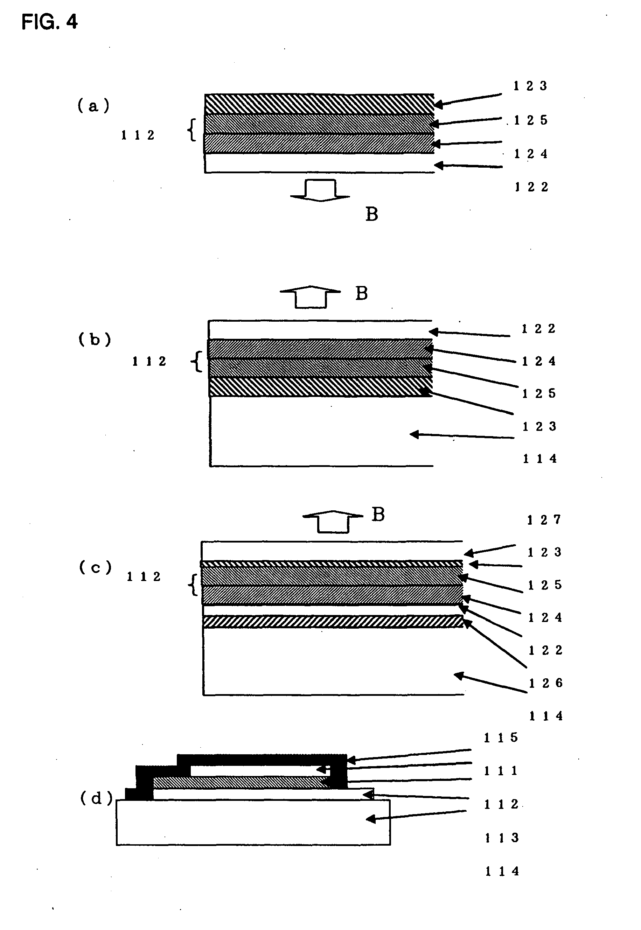

The structure of an organic EL will be describe with reference to the drawings. A concept of a light emitting device consisting of an organic EL will be described with reference to FIG. 4A. A light emitting device consisting of an organic EL has a structure where on an anode 122 made of transparent ITO (Indium Tin Oxide) are deposited an organic EL layer 121 and a cathode layer 123 having a smaller work function than that of the anode layer 122. Between a pair of electrodes 122 and 123 in the organic EL device having such a configuration, a desired power is applied from an unshown power supply to initiate light emission from the organic EL layer 112 sandwiched between the electrodes 122 and 123.

The anode layer 122 may be made of a metal having a large work function such as nickel, gold, platinum and palladium and their alloys; a metal compound such as tin oxide (SnO₂) and copper iodide; or a conductive polymer such as polypyrrol. Commonly used are transparent electrodes made of ITO.

A cathode layer 123 is preferably made of a material as a good electron injector. Specifically, a metal material with a small work function (low work-function metal material) whereby an electron injection efficiency can be improved is used; generally, aluminum and alloys such as magnesium-silver and aluminum-lithium. The organic EL layer 112 may have, for example, a two-layer structure where from the side of the anode layer 122 are sequentially deposited a hole transport layer 124 and an organic light-emitting layer 125. The hole transport layer may be made of N,N'-diphenyl-N,N'-bis(3-methylphenyl)1,1'-biphenyl-4,4'-diamine (triphenyldiamine; hereinafter, referred to as "TPD"), while the organic light-emitting layer may be made of tris(8-hydroxyquinalinato)aluminum (Tris(8-hydroxyquinolinato)Aluminium, abbreviated as "Alq").

It is known that the organic EL layer 112, in addition to the above structure, may have a three-layer structure comprising a hole-transporting layer efficiently transporting holes which is in contact with an anode electrode (anode), a light-emitting layer containing a light-emitting material and an electron-transporting layer efficiently transporting electrons which is in contact with a cathode electrode (cathode). In addition, there may be appropriately disposed a lithium fluoride layer, a layer of an inorganic metal salt and/or layers comprising thereof.

In the light-emitting layer 125, an emitted light outgoes from the anode side as a transparent electrode.

FIG. 4B shows a schematic structure of an organic EL device as another backlight source of this embodiment. On a substrate 114 is deposited aluminum to be a cathode to 100 nm by a common sputtering method. Subsequently, are sequentially deposited a light-emitting layer 125 to be an organic EL layer 112 and a hole transporting layer 124 to 100 nm each by an application method, and then an ITO film to be an anode 122 to 100 nm by sputtering. Thus, an emitted light (emitted light B) from the organic EL layer 112 outgoes from the anode side.

FIG. 4C shows a modified backlight source where on a substrate are sequentially deposited, as an organic EL device, an anode 122, a hole transport layer 124, a light-emitting layer 125 and a cathode 3. A process for producing an organic EL layer and thickness of each film are as described for FIG. 4B and thus are not described.

Since the anode 122 is an ITO film, i. e., a transparent film, the anode is a laminated film of a transparent electrode and an aluminum film as the reflection film 125. The aluminum film may be deposited to a thickness of 100 nm by sputtering as described for the cathode in FIG. 4B.

When using an ITO film as the anode 122 shown in FIG. 4C, the anode 122 may be formed on a reflection film (not shown). When the reflection film is an insulating film like a light-reflective polarizing film, the anode 122 may be directly formed on the light-reflective polarizing film. When the reflection film is made of an electrically conductive material such as aluminum, the anode 122 may be formed by the intermediary of a transparent insulating film, for example, an inorganic insulating film or an organic resin film (it may be a base film) with a thickness of about 100 nm.

For outputting a light to the side of the cathode 123, it is necessary that the aluminum film is sufficiently thin to prevent deterioration in transparency, thus giving a laminated film with an ITO film. After forming the aluminum film to 1 nm to 10 nm, a transparent electrode film such as an ITO film may be deposited. In this example, aluminum and an ITO film were deposited to 5 nm and 95 nm, respectively. When a thickness of the aluminum film is 1 nm or more, electron injecting performance is not deteriorated, while when it is 10 nm or less, transparency is not deteriorated.

The light-emitting layer must be white because it is used as a backlight source. There are no materials which alone can emit a white light. A white light is, therefore, emitted by producing, from a plurality of light-emitting material, a plurality of colored lights, which are then combined. Combination of a plurality of colored lights may involve production of three primary colors, i. e., red, green and blue, or utilization of complementary color system such as blue and yellow and blue-green and orange.

There are various methods for emitting a white light using an organic EL. The light may be emitted in accordance with any of these methods without any problems.

Since a light-emitting part in an organic EL device is an organic compound, the light-emitting part must be protected from an external atmosphere (e. g., moisture, oxygen). Thus, it is desirable to form, after forming the organic EL layer 112, a protective film made of SiO₂, SiN, Al₂O₃ or AIN. Although being not shown in this example, SiO₂ as a protective film is deposited to 200 nm by sputtering. For the protective film, a thickness of 0.1 µm or more is adequate for protecting the organic EL device. Although there are no particular restriction to an upper limit of the thickness, 1 µm or less is acceptable in practical manufacturing.

Even when using an organic EL device, the backlight unit requires a thickness of 600 nm to 1.2 µm including a counter electrode in a liquid crystal device, and a liquid crystal part requires a thickness of 3 to 6 µm. Adding 0.6 to 1 µm, i. e., a film thickness of the above driving circuit unit in the liquid crystal device, to the value, the total thickness of the polarizing film, the retardation film, the oriented film (X2) and the color filter film must be at least up to about 35 µm for making the distance between the pixel electrode and the reflection film smaller than the pixel electrode pitch.

Next, in this example, when using the polarizing film, the retardation film and the color filter as used in a conventional device film, it is difficult to make the distance between the pixel electrode and the reflection film smaller than the pixel electrode pitch. Thus, the polarizing film, the retardation film, the oriented film and the color filter film must be thin.

There will be described a polarizing film, a retardation film and a color filter film.

### <Polarizing film>

A polarizing film in this example may be a polarizing film made of a polyvinyl alcohol film in which iodine and/or a dichroic coloring agent such as a dichroic dye are adsorbed and oriented.

A polarizing film can be prepared by adsorption of iodine and/or a dichroic coloring agent such as a dichroic dye by a polyvinyl alcohol film made of a polyvinyl alcohol, a partially formated polyvinyl alcohol or a partially saponified ethylene-vinyl acetate copolymer, extension and then boric acid treatment. The polarizer has a thickness of, but not limited to, about 5 to 50 µm.

A so-called H film which is prepared by extending a polyvinyl alcohol thin film with heating and immersing the film in a solution containing a large amount of iodine (generally, called an H ink), i. e., a polyvinyl butyral film in which iodine is absorbed, can be used. The H film could give a film with a thickness of 18 µm.

In addition to adsorption of iodine and/or a dichroic coloring agent such as a dichroic dye by a polyvinyl alcohol film followed by two-axis extension, a polarizing film can be prepared by shaping a resin pellet containing iodine and/or dichroic dye into a film by, for example, melt extrusion or solution casting, and drawing the film to form a polarizing film in which iodine and/or a dichroic dye is strongly oriented in one axis direction. The polarizing film has a thickness of, but not limited to, about 5 to 50 µm. Thus, a polarizing film with a film thickness of 10 µm to 15 µm can be prepared.

Luminescence of an organic EL device and a Light emitted Diode does not include ultra violet radiation. Using an organic EL device or a Light emitted Diode for a back light for a Liquid crystal display, polarizing film does not consider ultraviolet [UV] radiation. Furthermore a protective film is formed on a luminescent layer of an organic EL device, and the protective film is made of optical transparent inorganic film as SiO₂, SiN, Al₂O₃ and AIN.

A polarizing film for a backlight is often placed just over a protective film in an organic EL. In such a case, a protective film on one side of the polarizing film can be omitted. It is, therefore, not necessary to form a protective film for a polarizing film as in the prior art.

A protective film may be made of a material including cellulose, polycarbonates, polyesters, acrylic compounds, polyether sulfones, polyamides, polyimides and polyolefins. Among these, preferred are celluloses such as triacetylcellulose; polyesters such as polycarbonates and polyethylene terephthalate; and acrylic compounds.

The protective film may contain a UV-ray absorber such as salicylate compounds, benzophenol compounds, benzotriazole compounds, cyanoacrylate compounds and nickel complex salt compounds. Each surface of the protective film may be processed by various methods to have, for example, a hard coat layer, an antireflection layer and an antiglare layer.

A thickness of a protective layer is generally 80 µm or less, preferably 40 µm or less in the light of, for example, weight reduction, protecting function, handling properties and crack resistance during cutting in the thin film. A thickness of 10 µm or more is adequate to prevent damage/cracks during shipping.

### <Retardation film>

An application type retardation film is formed by applying a polymerizable liquid crystal composition containing a liquid crystal compound having a polymerizable group on a support by a common application method to give a liquid crystal thin film. The surface which is not in contact with the substrate in the liquid crystal thin film is preferably in contact with the dust-removed dry air or an inert gas such as nitrogen, more preferably an inert gas such as nitrogen. Then, the polymerizable liquid crystal composition is oriented at a temperature within a range where a liquid crystal phase is formed, and then was polymerized to give a solid thin film. A film thickness and a birefringence of the retardation film are selected, depending on phase control properties required for a liquid crystal display panel.

Since the polymerizable liquid crystal composition is directly applied to the support, an application type retardation film may have a significantly reduced film thickness in comparison with a lamination type retardation film; specifically, a retardation film with a thickness of 0.5 to 10 µm can be obtained. A birefringence may generally vary within a range of 0.0 to 0.5 as a composition of the polymerizable liquid crystal composition varies. A film thickness and a birefringence can be determined, depending on a required retardation as in a 1/2 wavelength plate or a 1 /4 wavelength plate and convenient manufacturing conditions.

Next, there will be described a material for an application type retardation film.

A polymerizable liquid crystal compound used in this embodiment may be any compound which can be applied to a plastic sheet and can be oriented utilizing its liquid crystal state, but it must be a compound in which a temperature range where thermal polymerization of the polymerizable group is not initiated is at least partially contained in a temperature range where the compound is in a liquid crystal state. Furthermore, it must be able to be applied and oriented within the temperature range. A film having phase-difference controlling function in this invention preferably has a thickness as small as possible. In other words, a film having a higher birefringence is preferable. Specifically, a composition containing the following compound may be shown as an example.

A polymerizable liquid crystal composition where a monofunctional acrylate or methacrylate is represented by formula (1): 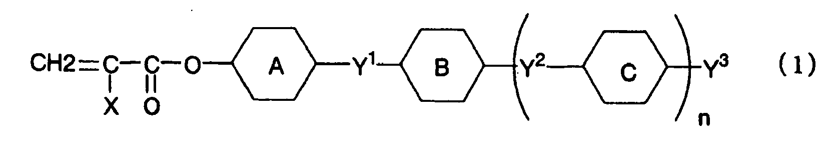 wherein X represents hydrogen or methyl; 6-membered rings A, B and C independently represent 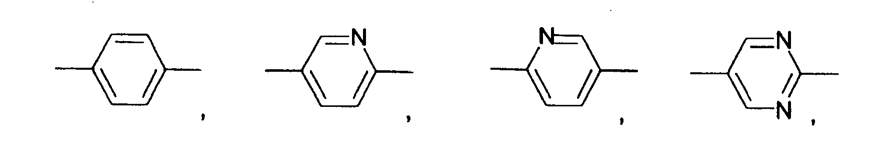 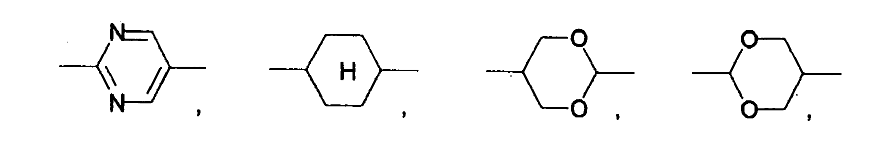 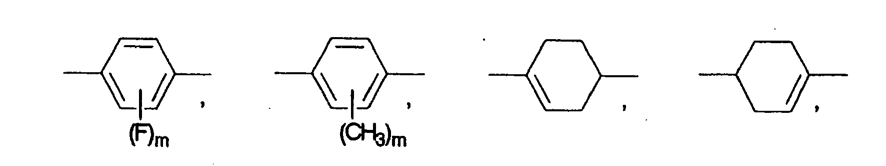 wherein n represents an integer of 0 or 1; m represents an integer of 1 to 4; Y1 and Y2 independently represent a single bond, -CH₂CH₂-, -CH₂O-, -OCH₂-, -COO-, -OCO-, -C(C-, -CH=CH-, -CF=CF-, -(CH₂)₄-, -CH₂CH₂CH₂O-, -OCH₂CH₂CH₂-, -CH=CHCH₂CH₂- or -CH₂CH₂CH=CH-; Y3 represents hydrogen, halogen, cyano, alkyl having 1 to 20 carbon atoms, alkoxy, alkenyl or alkenyloxy.

Next, there will be more specifically described a process for manufacturing an application type retardation film.

An application type retardation film is prepared by forming an oriented film on a transparent support, rubbing the film as necessary, applying a layer containing a polymerizable liquid crystal on the film, drying it by removing an unnecessary solvent, orienting the liquid crystal and decomposing a preliminarily added photo- or thermal-polymerization initiator by UV irradiation or heating to initiate polymerization of the liquid crystal. If necessary, a protective layer may be applied on the film.

The polymerizable liquid crystal is preferably dissolved in an appropriate solvent before application. Although the type of a solvent or a concentration cannot be generally determined because a liquid crystal has a different property depending on its structure, a solvent in which the liquid crystal is dissolved in a higher solubility is preferable in the light of providing a homogeneous thin film, preferably including halogen compounds such as dichloromethane and chloroform; ketones such as acetone and methyl ethyl ketone; esters such as ethyl acetate; amides such as dimethylacetamide, dimethylformamide and N-methyl-pyrrolidone; and alcohols such as isopropanol and perfluoropropanol.

It is well known in a liquid crystal that an oriented film may often give significant influence on molecular orientation during forming a liquid crystal phase, and an inorganic or organic oriented film is used. Although there may be a combination of a liquid crystal and a support in which an effective orientation may be obtained only by rubbing the support surface and then applying the combination on it, the most universal method involves the use of an oriented film.

Typical examples of an oriented film formed on a support include an SiO evaporated film as an inorganic rhombic evaporated film and a polyimide film in which an organic polymer film has been rubbed.

A typical example of an organic oriented film is a polyimide film. In this film, a polyamic acid (for example, AL-1254 (JSR Corporation), SE-7210 (Nissan Chemical Industries, Ltd.)) can be applied on a support surface, fired at a temperature of 100°C to 300°C and then rubbed to orient the liquid crystal. A coating film of alkyl-chain modified Poval (for example, MP203, R1130 (both from Kuraray Co., Ltd.)) can be endowed with the orienting ability only by rubbing without firing. In addition, most of organic polymer films giving a hydrophobic surface such as polyvinylbutyral and polymethyl methacrylate may be endowed with a liquid crystal orienting ability only by rubbing the surface.

A typical inorganic rhombic evaporated film is an SiO rhombic evaporated film. It is prepared by colliding SiO vaporized particles on a support surface from an oblique direction in a vacuum chamber to form an oblique evaporated film with a thickness of about 20 to 200 nm as an oriented film. With the evaporated film, when the liquid crystal is oriented, an optical axis of the liquid crystal layer is oriented to a particular direction on a plane perpendicular to the support surface including the track of SiO vapor-deposited particles.

In addition to the above method, a polymerizable liquid crystal applied on a support may be also oriented by magnetic-field or electric-field orientation. In this method, after applying on a support, a liquid crystal compound may be oriented to an oblique direction, using a magnetic or electric field from a desired angle.

In the manufacturing process for a retardation film, a common application method may be employed. Specifically, it may be formed as a liquid crystal thin film on a support by an application step using an appropriate method such as flexographic printing, gravure printing, dip coating, curtain coating and extrusion coating and then a drying step.

Using a flexo press, on a roll of a base film roll made of a polyether sulfone surface-treated with silicon oxide was applied a polyimide orienting agent "AL-1254" (JSR Corporation) as an oriented film, which was then dried at 180°C for 1 hour and rubbed with a rayon cloth.

In addition, a coating film of an alkyl-chain modified poval (for example, Kuraray Co., Ltd., MP203 or R1130) may be endowed with such orienting ability by rubbing without firing. Furthermore, most organic polymer films which form a hydrophobic surface such as polyvinyl butyral and polymethyl methacrylate may be endowed with liquid crystal orienting ability by rubbing its surface.

A polymerizable liquid crystal composition (A) was prepared from 50 parts by weight of a compound represented by formula (2): 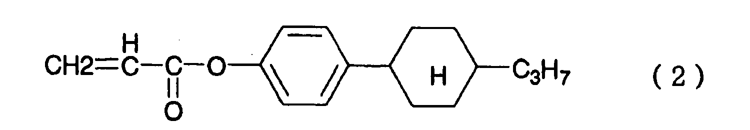 and 50 parts by weight of a compound represented by formula (3): 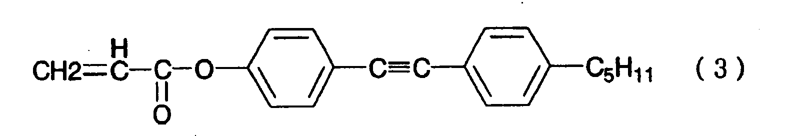 The composition thus prepared showed a nematic phase at room temperature, and a transition temperature from a nematic phase to an isotropic phase was 47°C. An nₑ (extraordinary-ray refractive index) and nₒ (ordinary refractive index) at 25°C were 1.65 and 1.52, respectively. In methyl ethyl ketone was dissolved a polymerizable liquid crystal composition (C) consisting of 100 parts by weight of the polymerizable liquid crystal composition (A) and 1 part by weight of a photopolymerization initiator "IRG-651" (Ciba-Geigy). The solution was applied on the base film roll previously prepared, using a gravure coater, and then irradiated with UV rays at 365 nm at room temperature to 160 mJ/cm² for initiating curing of the polymerizable liquid crystal composition, to form a retardation film with a thickness of 1.6 µm. It was observed that the retardation film had a phase difference of 138 nm to a light with a wavelength of 550 nm and acts as a 1/4 wavelength plate.

### <Color filter>

A colored composition may be applied by an ink-jet process. Here, although it may be directly applied to a substrate, a color filter may be formed on an intermediate support by an ink-jet process followed by transfer. In this example, there is described a case where it is directly drawn on a substrate, but it may be drawn on an intermediate supporting film followed by transfer onto a substrate. When the substrate is flexible, it is desirable in practical manufacturing to draw it on an intermediate film before transfer, but direct drawing may be satisfactorily conducted.

The intermediate support may be a film made of a material selected from polyimide resins, PVA derivative resins, acrylic resins and epoxy resin compositions.

Examples of a resin material used for forming a color filter layer include, but not limited to, polyimide resins, PVA derivative resins and acrylic resins. For example, in terms of an acrylic resin, suitable resins are those with a molecular weight of about 5×10³ to 100×10³ prepared using about 3 to 5 monomers selected from alkyl acrylates or alkyl methacrylates such as acrylic acid, methacrylic acid, methyl acrylate and methyl methacrylate; cyclic acrylates and methacrylates; and hydroxyethyl acrylate and methacrylate.

A diluting monomer may be, if necessary, added for adjusting properties such as viscosity and curability of a color filter layer. Examples of a diluting monomer include bifunctional monomers such as 1,6-hexanediol diacrylate, ethyleneglycol diacrylate, neopentylglycol diacrylate and triethyleneglycol diacrylate; trifunctional monomers such as trimethylolpropane triacrylate, pentaerythritol triacrylate and tris(2-hydroxyethyl) isocyanate; and multifunctional monomers such as di(trimethylolpropane) tetraacrylate and di(pentaerythritol) penta- and hexa-acrylates. A suitable content of the diluting monomer is about 20 to 150 parts by weight to 100 parts by weight of the acrylic resin.

Examples of a pigment used for preparing a colored composition include organic dyes, i.e., red pigments such as C. I. Nos. 9, 19, 81, 97, 122, 123, 144, 146, 149, 168, 169, 177, 180, 192 and 215, green pigments such as C. I. Nos. 7 and 36, blue pigments such as C. I. Nos. 15:1, 15:2, 15:3, 15:4, 15:6, 22, 60 and 64, purple pigments such as C. I. Nos. 23 51319 and 39 42555:2, yellow pigments such as C. I. Nos. 83, 138, 139, 101, 3, 74, 13 and 34, black pigments such as carbon, and body pigments such as barium sulfate, barium carbonate, alumina white and titanium.

A dispersing agent used for preparing a colored composition may be a surfactant, a pigment intermediate, a dye intermediate or Solsperse. Suitable examples of an organic dye derivative include azo, phthalocyanine, quinacridone, anthraquinone, perylene, thioindigo, dioxane and metal complex salt derivatives. The organic dye derivatives are appropriately selected from those having a substituent such as hydroxy, carboxyl, sulfone, carboxamide and sulfonamide which exhibit good dispersibility.

A content of the pigment is about 50 parts by weight to 150 parts by weight to 100 parts by weight of an acrylic resin. A content of a dispersing agent is about 1 part by weight to 10 parts by weight to the pigment. For adjusting spectral properties of a color filter, a suitable pigment may be added as appropriate.

A thermal crosslinking agent used for preparing a colored composition may be a melamine resin or an epoxy resin. Examples of a melamine resin include alkylated melamine resin such as a methylated melamine resin and a butylated melamine resin and mixed etherated melamine resins, which may be of a high-condensation type or a low-condensation type.

Examples of the above epoxy resin include glycerin, polyglycidyl ether, trimethylolpropane polyglycidyl ether, resorcinol diglycidyl ether, neopentylglycol diglycidyl ether, 1,6-hexanediol diglycidyl ether and ethyleneglycol(polyethyleneglycol) diglycidyl ether.

A content of a thermal crosslinking agent is suitably 10 to 50 parts by weight to 100 parts by weight of an acrylic resin. Suitable examples of a solvent used for preparing a colored composition include toluene, xylene, ethyl cellosolve, ethyl cellosolve acetate, diglyme, cyclohexanone, ethyl lactate and propyleneglycol monomethyl ether acetate which may be used alone or in combination of two or more, depending on a monomer composition, a particular thermal crosslinking agent and a diluting monomer.

A colored composition used for forming a color filter layer comprises a resin, a pigment, a dispersing agent, a thermal crosslinking agent and a solvent as described above. The colored composition is prepared as follows. First, an acrylic resin and a pigment are kneaded using three rolls into chips, to which are then added a dispersing agent and a solvent to prepare a paste. To the paste are added a thermal crosslinking agent and a diluting monomer to prepare an application solution of a colored composition.

On a supporting substrate are applied the application solutions of black (black matrix), red, green and blue in a predetermined pattern by an ink-jet process. Ink-jet apparatuses may be classified into a piezo conversion system or a heat conversion system, based on difference in an ink discharge system. In particular, a piezo conversion system is suitable. Preferred is an apparatus with an ink atomizing frequency of about 5 to 100 KHz and a nozzle diameter of about 1 µm to 80 µm, having four heads, each of which has 1 to 1,000 nozzles.

The number of heads may vary depending on the number of colors to be applied. When three colors, i. e., red, green and blue, are applied, three heads are used. Preferably, the number of heads are at least equal to the number of colors applied and each head is assigned to each color.

Before applying the solution on the supporting substrate by an ink-jet process, an underlying layer matching a resin and/or a solvent in the application solution may be formed for adjusting ink receptivity and wettability in advance. The underlying layer may be made of a polyimide resin, a PVA derivative resin, an acrylic resin and/or an epoxy resin composition, to which porous particles of silicon oxide or alumina may be added. A matrix light-shielding layer may be formed by a photolithographic method or the above transfer method, which may be conducted before or after forming the color filter layer by an ink-jet process.

If necessary, over the color filter layer may be formed an overcoat layer, which is used for improving apparent flatness, durability represented by moisture resistance and chemical resistance in the color filter layer, and for ensuring barrierhood for preventing elution from the color filter layer. Examples of a material suitably used include transparent resins such as thermosetting acrylic copolymers containing maleimide and epoxy resin compositions. The color filter formed on the supporting substrate can be transferred to a functional film as described for a film type color filter.

By the above configuration, a color filter film with a thickness of 1 µm to 5 µm can be formed. In this example, a color filter film with a thickness of 1.5 µm could be formed.

Without being limited to this example, a color filter may be, of course, prepared by any manufacturing process and with any material as long as a color filter film with a film thickness of several micrometers.

### <Liquid-crystal panel>

A liquid-crystal orienting agent is applied, by an appropriate method such as roll coating, spinner coating, printing and ink-jet printing, on a first substrate in which the color filter film and the spacer described above are sequentially laminated on a TFT glass substrate for a liquid-crystal panel, and on a second substrate in which a polarizing film and a retardation film are sequentially laminated on a substrate comprising an organic EL device and a transparent electrode made of an ITO to be a counter electrode in a liquid crystal device is deposited to 200 nm by sputtering. Then, the applied surface is heated to form a coating film. In applying a liquid-crystal orienting agent, a functional silane-containing compound or a functional titanium-containing compound can be preliminarily applied to the surface of the substrate for further improving adhesiveness of the substrate surface to the coating film. After applying the liquid-crystal orienting agent, the film is heated at a temperature equal to or lower than an upper temperature limit for each of functional films A and B, preferably 80 to 230°C, more preferably 100 to 200°C.

The coating film formed has a thickness of preferably 0.001 to 1 µm, more preferably 0.005 to 0.5 µm. In this example, an oriented film with a thickness of 0.1 µm was formed.

The surface of the coating film formed is rubbed in a certain direction with a roll which is wrapped with a cloth made of fiber such as Nylon, Rayon and cotton. Thus, the coating film is endowed with liquid-crystal molecule orienting ability to become a liquid crystal oriented film.

Then, a liquid crystal is injected into a space between the oriented films of the first and the second substrates which face each other, and then sealed by applying a sealing material (not shown), to provide a liquid-crystal panel comprising the organic EL device as a backlight of this example.

In this example, the polarizing film is a so-called H film with a thickness of 12 µm prepared by extending a polyvinyl alcohol thin film with heating and then immersing it in a solution containing a large amount of iodine (generally, called an H ink) for iodine to be absorbed by the film.

A pitch of pixel electrodes in FIG. 1 depends on a resolution of the active driving type liquid crystal display panel. For example, for an active driving type liquid crystal display panel comprising three color filters of R (red), G (green) and B (blue) with a resolution of 200 ppi (pixEL per inch), a pitch of pixel electrodes is 25400 µm/200/3 = 42.3 µm. A thickness of the liquid crystal layer is generally 2 to 6 µm.

In this example, a distance between the pixel electrode and the reflection film is about 20 to 24 µm; specifically, 22 µm in the structure shown in FIG. 1. It is about a half of the pixel electrode pitch (about 42 µm). Thus, a distance between the pixel electrode and the reflection film can be adequately smaller than the pixel electrode pitch.

There will be described operation of the liquid-crystal panel of this example.

First, there will be described operation as a transmissive liquid crystal display panel. A white light which is emitted from an organic EL layer 112 as a light-emitting layer and then passes through a protective layer (not shown) is non-polarized, but only one linearly-polarized light passes through a polarizing layer 110, to a liquid crystal layer 106. Here, an orientation state of liquid crystal molecules is controlled by the presence or the absence of an applied potential to a transparent electrode in the pixel. That is, in an extreme orientation state, a linearly-polarized light entering from the bottom of FIG. 1 passes through the liquid crystal layer 106 as it is. A light at a wavelength within a particular range passes through the pixel electrode 403 consisting of the color filter and the pixel electrode 103 as a transparent electrode in the pixel and then substantially completely absorbed by the polarizing layer 100. Therefore, the pixel develops black.

In contrast, in another extreme orientation state, a polarization state of a light passing through the liquid crystal layer 106 is changed and a light passing through the color filter 104 substantially totally passes through the polarizing layer 100. Therefore, this pixel most strongly develops a color determined by a color filter. In an orientation state between these extremes, a light partially passes through the layer, so that the pixel develops an intermediate color.

Secondly, there will be described operation as a reflective liquid-crystal panel. Here, a voltage is not applied to the organic EL device in the backlight. An outside light entering the active driving type liquid-crystal panel from above FIG. 1 passes through the polarizing layer 100 to be a linearly-polarized light, which then passes through the transparent pixel electrode 103 for the pixel, and thus a light having a particular range of wavelength is transmitted through the color filter and reaches the liquid crystal layer 106. Here, an orientation state of the liquid crystal molecules is controlled by the presence or the absence of an applied potential to the transparent pixel electrode 103.

That is, in an extreme orientation state, a linearly-polarized light entering the liquid crystal layer 106 from above FIG. 1 changes its polarity during passing through the liquid crystal layer 106, and substantially completely passes through the polarizing layer 110. This linearly-polarized light sequentially pass through a protective film (not shown), the transparent electrode 111 in the organic EL device and the organic EL layer 112 to be a light-emitting layer, and finally reflected by the reflection electrode 113. Thus, the reflection electrode 113 in the backlight acts as a reflection film.

In turn, the reflected linearly-polarized light sequentially pass through the organic EL layer 112 to be a light-emitting layer, the transparent electrode 111, the protective film (not shown), the polarizing layer 110 and the retardation film 109, and then reaches the liquid crystal layer 106. The light changes its polarity during passing through the liquid crystal layer 106 and is transmitted with being little absorbed by the color filter 104. Subsequently, this light sequentially passes through the pixel electrode 103 in the pixel and the glass substrate 101, and is then emitted out with little being absorbed by the polarizing layer 100, the retardation film or the anti-reflection film (not shown). Therefore, this pixel most strongly develops a color determined by the color filter 104.

In another extreme orientation state, in contrast, the light passing through the color filter 104 is substantially completely absorbed by the retardation film, the polarizing layer and the anti-reflection film (not shown) without change in the polarity of the light passing through the liquid crystal layer 106. Therefore, this pixel develops black. In an intermediate orientation state between these two states, a light is partially transmitted, so that the pixel develops an intermediate color.

The retardation film 109 is necessary in terms of expanding an angle of field, but is not essential for operation.

The operation as a reflective liquid-crystal panel described above is as is the operation of a reflective liquid-crystal panel generally known as a two polarizing plate system. However, this invention is characterized in that the electrode in the organic EL device as a backlight is also used as a reflection plate, and that a distance between the reflection plate and the color filter is smaller than the pixel electrode pitch. That is, because the panel is provided with a backlight, it also operates as a transmissive liquid-crystal panel, so that visibility in a dark place can be ensured. Furthermore, if a distance between the reflection plate and the pixel electrode is equal to or less than the pixel electrode pitch, an efficiency of an outside light obliquely entering the pixel electrode is not reduced because a light entering from the color filter is not diffused to an adjacent color filter.

Furthermore, by adding a material capable of diffusing forward a light to a color filter with the configuration of this example, interference by an external image due to regular reflection of a light in the reflection electrode can be minimized when the panel acts as a reflective liquid-crystal panel. Besides a color filter, such a material capable of diffusing a light can be used to form a dedicated diffusing layer, which can be inserted between the upper substrate and the reflection electrode.

Alternatively, instead of adding a material capable of diffusing forward a light, the reflection electrode in the organic EL device as a backlight has an irregular shape with a height of about 1 µm. A size distribution in the irregularity may be random. Here, since the reflection electrode in the organic EL device can diffuse a light, the above problem of interference by an external image can be solved.

When the color filter material is electrically conductive, a voltage applied to a transparent electrode in a pixel for applying a given voltage to the liquid crystal can be reduced. Therefore, the color filter material is desirably electrically conductive.

The color filter, the polarizing film, the retardation film and the oriented film used in this example are not limited to those described herein, and may, of course, have any configurations which meet requirement for properties and whose film thickness is small.

In the first example, the electrode in the side where an outside light enters (the electrode formed on the glass substrate 101) in the liquid crystal device unit comprises a thin-film transistor and an interconnection, but a similar configuration and operation may be achieved by forming a counter electrode. It is also clear that a manufacturing process can be conducted as described above.

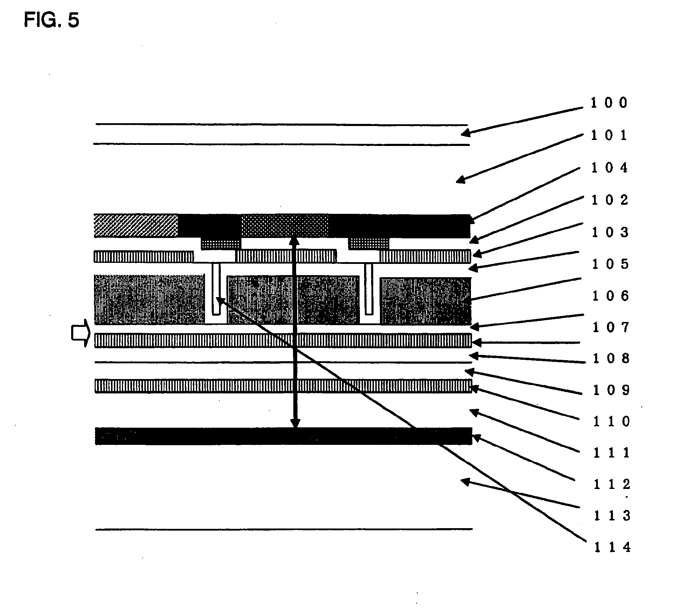

Next, there will be described variation 1 of the example with reference to the drawings. While the color filter film is formed on the pixel electrode in the first example, a color filter film is formed on a substrate in variation 1 shown in FIG. 5.

In FIG. 5, there is formed a TFT glass substrate for a liquid-crystal panel in which a color filter film 104, a thin-film transistor, an interconnection 103 and a pixel electrode 103 are formed on a first substrate 101.

In variation 1, the material for the substrate may be not a glass, but an organic resin by employing a manufacturing process described later.

There is formed a substrate comprising an organic EL device in which a reflection electrode 113, an organic EL layer 112, a transparent electrode 111, a polarizing film 110, a retardation film 109 and a counter electrode 108 are formed on a substrate 114.

As described in Example 1, oriented films 105, 107 are formed on a first substrate in which a spacer is disposed on the TFT substrate for a liquid-crystal panel, and on a second substrate in which on the substrate comprising the organic EL device are sequentially laminated the polarizing film 110 and the retardation film 109 and a transparent electrode made of ITO to be a counter electrode for a liquid crystal device is deposited to 200 nm by sputtering. Then, the space between the oriented films facing each other is filled with a liquid crystal and sealed to provide a liquid-crystal panel. Its operation is as described in Example 1 and will not be, therefore, described.

Since the thin-film flat light emitting device unit consisting of the organic EL is not exposed to an elevated temperature in contrast to the thin-film transistor in the liquid-crystal panel, any material including an organic resin instead of a glass may be used for a substrate as long as the substrate prepared is resistant to a temperature of 200°C to 250°C. It can be also applicable to Example 1 and other variations of this invention. Even in the structure of Example 1, a substrate made of a material other than a glass may be used by employing the manufacturing process described below.

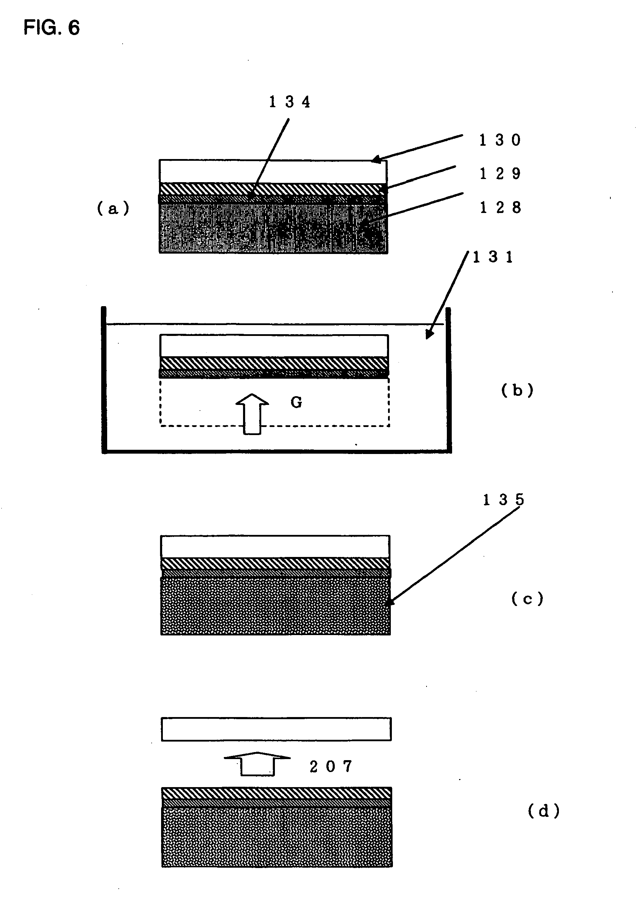

Variation 1 relates to formation of a thin-film transistor on a color filter, which is prepared by the process shown in FIG. 6.

For the formation of the electrode protective film and the previous steps, the manufacturing process is as shown in FIG. 3. Then, as shown in FIG. 6A, a protective film 130 is laminated on a transistor-forming surface in a supporting substrate (a glass substrate, a quartz substrate, a silicon substrate or an organic resin substrate) 128 comprising a transistor array layer 129 via an adhesive. In this example, a case where a glass substrate is used will be described. Next, as shown in FIG. 6B, the substrate covered by the protective substrate is immersed in hydrofluoric acid as a glass etchant 24 to etch the glass substrate from its rear side. Besides hydrofluoric acid, a suitable glass etchant may be a buffered hydrofluoric acid. After completing the etching of the glass substrate, a substrate 131 comprising a color filter layer on its surface is laminated via an adhesive as shown in FIG. 6C. Finally, as shown in FIG. 6D, the protective film 130 and the adhesive are removed to complete the transfer. Thus, a device layer is formed on the base film.

The supporting substrate 128 may be, instead of etching, polished (either mechanical or chemical-mechanical polishing), and for an organic resin substrate, peeling may be employed.

Lamination of the protective film 130 to the substrate or of the substrate to the transistor array layer may be conducted, instead of using an adhesive, by making the protective film itself adhesive or by hot pressing.

The substrate 131 may be a glass substrate, a quartz substrate or an organic resin substrate as in the supporting substrate.

In the configuration of variation 1, the color filter is disposed outside of the liquid crystal pixel, resulting in no restrictions to a thickness. Therefore, since there are no restrictions to a film thickness of the color filter film in contrast to Example 1, any kind of color filter may be used with no problems. However, in the light of weight reduction and thickness reduction in the liquid-crystal panel, it is preferable to use a thin film type color filter film.

Although the electrode in the side in the liquid crystal device which an outside light enters comprises the thin-film transistor in Example 1 and variation 1, a thin-film transistor may be deposited on a substrate comprising a rear-face light source as described above (not shown). In such a case, the side which an outside light enters comprises a counter electrode.

Even when a positional relationship of the pixel electrode and the counter electrode to the liquid crystal is changed, the liquid crystal device unit exhibits the same properties and operation.

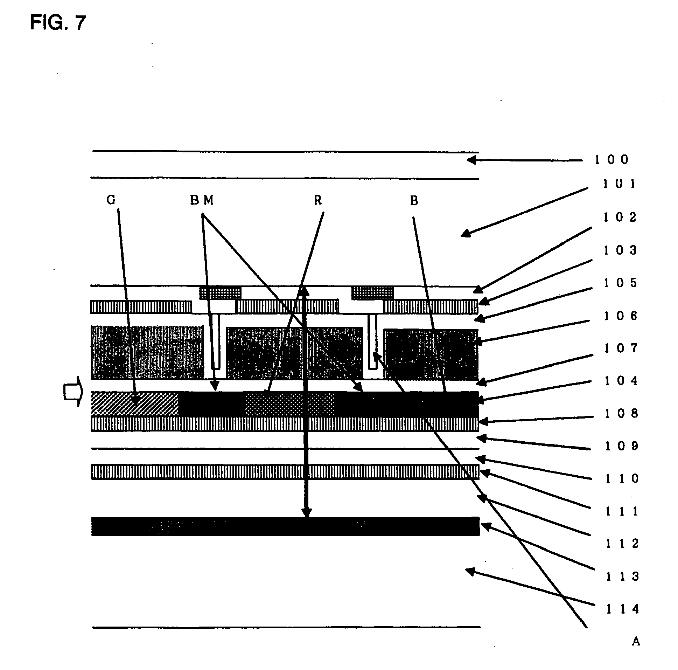

There will be described formation of a color filter on a substrate comprising a color filter as variation 2 of the first example with reference to FIG. 7.

In variation 2, a color filter layer 104 is disposed in the liquid crystal (106) side in a counter electrode 108. Although the same components as the first example and variation 1 will not be described, there are sequentially deposited a counter electrode 108, a color filter 104, an oriented film 105 and a liquid crystal 106 in variation 2.

Although being not shown, the color filter 104 may be disposed in any place nearer to the liquid crystal (106) side than the reflection electrode 113 and nearer to the liquid crystal 106 than an organic EL layer 112 to be a light-emitting layer.

The retardation film 109 and the polarizing film 110 may be disposed in any place between the liquid crystal 106 and the organic EL layer 112 to be a light-emitting layer.

This invention is not restricted to the above examples. Thus, by varying a liquid crystal device, a backlight and/or a structure, various embodiments of this invention may be realized as long as a variation is within a concept of this invention that a distance between a reflection film and a pixel electrode in a liquid crystal which an outside light enters is smaller than a pixel electrode pitch in a liquid crystal device. These variations are, of course, encompassed by this invention.

A liquid-crystal panel of this invention is mounted in an electronic device as a display device. The panel is particularly effective when being used as a display device for a mobile electronic device which is used both indoors and outdoors (a mobile information terminal such as a cell phone, a digital camera, a digital video camera, a notebook type personal computer and a PDA).

## Claims

1. A liquid-crystal panel comprising a rear-emitting light source, comprising
a liquid crystal device formed on a first substrate in which a liquid crystal layer is sandwiched between a transparent first electrode and a transparent second electrode which at least face each other and
a rear-emitting light source for the liquid crystal device formed on a second substrate in which a thin-film flat light emitting device is sandwiched between an optically opaque third electrode and a transparent fourth electrode which at least face each other, wherein
the third electrode is a reflection film disposed in the side of the second substrate, which reflects an outside light entering through the liquid crystal layer into the liquid crystal layer; and
the fourth electrode is disposed facing the second electrode, and the insulating film sandwiched between the fourth electrode and the second electrode is a film continuously formed on the fourth electrode.

2. The liquid-crystal panel as claimed in Claim 1, wherein a distance between the third electrode and the pixel electrode is smaller than a pixel electrode pitch in the liquid crystal device.

3. The liquid-crystal panel as claimed in Claim 1, wherein the first and the second substrates are made of glass, quartz or an organic resin.

4. The liquid-crystal panel as claimed in Claim 1, wherein the third electrode is a reflection film for light emission in the thin-film flat light emitting device.

5. The liquid-crystal panel as claimed in Claim 1, wherein the third electrode is a laminated structure of a transparent electrode and an opaque electrode.

6. The liquid-crystal panel as claimed in Claim 5, wherein the uppermost layer in the third electrode is a transparent electrode.

7. The liquid-crystal panel as claimed in Claim 5, wherein the uppermost layer in the third electrode is an opaque electrode.

8. The liquid-crystal panel as claimed in Claim 1, wherein the thin-film flat light emitting device is an organic EL device.

9. The liquid-crystal panel as claimed in Claim 8, wherein the protective film for protecting the organic EL device is formed on the fourth electrode.

10. The liquid-crystal panel as claimed in Claim 9, wherein the protective film covers at least the upper surface and the edge in the organic EL device which are not covered by the transparent electrode.

11. The liquid-crystal panel as claimed in Claim 9, wherein the protective film is made of SiO₂, SiN, Al₂O₃ or AIN.

12. The liquid-crystal panel as claimed in Claim 1, wherein the substrate made of at least the organic resin comprises a barrier film at least in one side.

13. The liquid-crystal panel as claimed in Claim 12, wherein the barrier film is formed at least in the liquid crystal layer in the substrate or in the surface where the thin-film flat light emitting device is formed.

14. The liquid-crystal panel as claimed in Claim 12, wherein the barrier film is formed in the liquid crystal layer in the substrate, in the surface where the thin-film flat light emitting device is formed, or in the surface facing the above surface.

15. The liquid-crystal panel as claimed in Claim 12, wherein the barrier film is made of an organic material consisting of a polyvinyl alcohol.

16. The liquid-crystal panel as claimed in Claim 12, wherein the barrier film is made of an organic material consisting of a polyvinyl alcohol and an organic-inorganic composite material consisting of an organic material and a clay mineral.

17. The liquid-crystal panel as claimed in Claim 12, wherein the barrier film is made of a crystalline clay mineral.

18. The liquid-crystal panel as claimed in Claim 1, wherein the liquid crystal device has a configuration where on the first substrate are sequentially disposed a color filter film; the first electrode consisting of at least a pixel electrode and a transistor driving the pixel electrode; a first oriented film; a liquid crystal; a second oriented film; and the second electrode.

19. The liquid-crystal panel as claimed in Claim 1, wherein the liquid crystal device has a configuration where on the first substrate are sequentially disposed the first electrode consisting of at least a pixel electrode and a transistor driving the pixel electrode; a color filter film; a first oriented film; a liquid crystal; a second oriented film; and the second electrode.

20. The liquid-crystal panel as claimed in Claim 1, wherein the liquid crystal device has a configuration where on the first substrate are sequentially disposed the first electrode consisting of at least a pixel electrode and a transistor driving the pixel electrode; a first oriented film; a liquid crystal; a second oriented film; the second electrode; and a color filter film.

21. The liquid-crystal panel as claimed in Claim 1, wherein the liquid crystal device has a configuration where on the first substrate are sequentially disposed the first electrode consisting of at least a pixel electrode and a transistor driving the pixel electrode; a first oriented film; a liquid crystal; a second oriented film; a color filter film; and the second electrode.

22. A liquid-crystal panel wherein a rear-emitting light source comprises a reflection film formed between a substrate and one surface of a thin-film flat light emitting device, and a transparent electrode formed on the other surface of the thin-film flat light emitting device; an outside light from a liquid crystal device enters the reflection film through the transparent electrode; the outside light reflected by the reflection film enters the liquid crystal device through the transparent electrode; and
the liquid crystal device is adjacent to the rear-emitting light source via a film continuously formed at least on the transparent electrode.

23. The liquid-crystal panel as claimed in Claim 22, wherein in the liquid crystal device, a liquid crystal is sandwiched at least between a pixel electrode and a counter electrode which face each other.

24. The liquid-crystal panel as claimed in Claim 22, wherein a distance between an electrode in the side in the liquid crystal device which an outside light enters and a reflection film is smaller than the pixel electrode pitch.

25. The liquid-crystal panel as claimed in Claim 22, wherein the reflection film is a driving electrode for the rear-emitting light source.

26. The liquid-crystal panel as claimed in Claim 25, wherein the driving electrode is a laminated film consisting of a transparent electrode and an opaque electrode.

27. The liquid-crystal panel as claimed in Claim 26, wherein in the laminated film, the uppermost layer film is a transparent electrode.

28. The liquid-crystal panel as claimed in Claim 26, wherein in the laminated film, the uppermost layer film is an opaque electrode.

29. The liquid-crystal panel as claimed in Claim 22, wherein a driving electrode for driving the rear-emitting light source is formed on the reflection film.

30. The liquid-crystal panel as claimed in Claim 29, wherein the reflection film is electrically conductive.

31. The liquid-crystal panel as claimed in Claim 30, wherein the reflection film and the driving electrode are separated via an insulating film.

32. The liquid-crystal panel as claimed in Claim 22, wherein the reflection film has an irregularity.

33. The liquid-crystal panel as claimed in Claim 22, wherein the thin-film flat light emitting device is an organic EL device.

34. The liquid-crystal panel as claimed in Claim 33, wherein a protective film for protecting the organic EL device is formed on the transparent electrode.

35. The liquid-crystal panel as claimed in Claim 34, wherein the protective film covers at least the upper surface and the edge in the organic EL device which are not covered by the transparent electrode.

36. The liquid-crystal panel as claimed in Claim 34, wherein the protective film is made of SiO₂, SiN, Al₂O₃ or AIN.

37. The liquid-crystal panel as claimed in Claim 22, wherein the substrate is made of an organic resin and a barrier film is formed at least on one side of the substrate.

38. The liquid-crystal panel as claimed in Claim 37, wherein the barrier film is formed at least in the surface in the substrate where the organic EL device is formed.

39. The liquid-crystal panel as claimed in Claim 37, wherein the barrier film is formed in the surface in the substrate where the organic EL device is formed, or in the surface facing the above surface.

40. The liquid-crystal panel as claimed in Claim 37, wherein the barrier film is made of an organic material consisting of a polyvinyl alcohol.

41. The liquid-crystal panel as claimed in Claim 37, wherein the barrier film is made of an organic material consisting of a polyvinyl alcohol and an organic-inorganic composite material consisting of an organic material and a clay mineral.

42. The liquid-crystal panel as claimed in Claim 37, wherein the barrier film is made of a crystalline clay mineral.

43. The liquid-crystal panel as claimed in Claim 22, wherein the continuously formed films include at least an insulating film, a counter electrode formed on the insulating film for the liquid crystal device and an oriented film.

44. The liquid-crystal panel as claimed in Claim 43, wherein the insulating film is a laminated film comprising at least a polarizing film.

45. The liquid-crystal panel as claimed in Claim 43, wherein the insulating film comprises at least a polarizing film and a retardation film.

46. The liquid-crystal panel as claimed in Claim 43, wherein the insulating films include at least a polarizing film, a retardation film and a color filter film.

47. The liquid-crystal panel as claimed in Claim 22, wherein the liquid crystal device consists of at least a color filter film; a first electrode consisting of at least a pixel electrode and a transistor driving the pixel electrode; a first oriented film; a liquid crystal; a second oriented film; and a counter electrode.

48. The liquid-crystal panel as claimed in Claim 22, wherein the liquid crystal device consists of a first electrode consisting of at least a pixel electrode and a transistor driving the pixel electrode; a color filter film; a first oriented film; a liquid crystal; a second oriented film; and a counter electrode.

49. The liquid-crystal panel as claimed in Claim 22, wherein the liquid crystal device consists of a first electrode consisting of at least a pixel electrode and a transistor driving the pixel electrode; a first oriented film; a liquid crystal; a second oriented film; a counter electrode; and a color filter film.

50. A liquid-crystal device comprising the liquid-crystal panel as claimed in any of Claims 1, 2 and 22.

51. The electronic device as claimed in Claim 50, comprising the liquid-crystal device.

52. The electronic device as claimed in Claim 51, wherein the electronic device is a mobile device.

53. A process for manufacturing a liquid-crystal panel, comprising the steps of:
forming one of a counter electrode for a liquid crystal, a pixel electrode or a transistor array layer as a driving circuit on a first substrate;
forming a reflection film on a second substrate;
then forming a thin-film flat light emitting device;
then forming an optically functional film;
then forming an electrode facing the electrode formed on the first substrate;
forming a first oriented film on the electrode on the first substrate;
forming a second oriented film on the electrode on the second substrate which faces the electrode on the first substrate; and
disposing the first oriented film and the second oriented film such that these face each other and filling a liquid crystal in the space between the first oriented film and the second oriented film.

54. The process for manufacturing a liquid-crystal panel as claimed in Claim 53, wherein the step of forming the optically functional device comprises the steps of forming a polarizing film and forming a retardation film.

55. The process for manufacturing a liquid-crystal panel as claimed in Claim 53, wherein the step of forming a thin-film flat light emitting device consists of the steps of forming an organic light-emitting layer and forming an electrode in the organic light-emitting layer.

56. The process for manufacturing a liquid-crystal panel as claimed in Claim 53, further comprising the step of forming a protective film for protecting the thin film light emitting device after forming the thin film light emitting device.

57. The process for manufacturing a liquid-crystal panel as claimed in Claim 53, further comprising the step of forming a color filter after forming the transistor array layer.

58. The process for manufacturing a liquid-crystal panel as claimed in Claim 53, wherein the transistor array layer is formed after forming a color filter on the first substrate.
